# FASCICULE DE BREVET EUROPEEN

(11) **EP 2 870 271 B1**
(45) Date de publication et mention de la délivrance du brevet: **09.02.2022**
(21) Numéro de dépôt: 13739768.3
(22) Date de dépôt: 01.07.2013
(51) Int. Cl.: C23C 10/04, C23C 10/08

(54) **PROCÉDÉ ET OUTILLAGE POUR LE DÉPÔT D'UN REVÊTEMENT MÉTALLIQUE EN PHASE VAPEUR SUR DES PIÈCES EN SUPER ALLIAGES**
VERFAHREN UND WERKZEUG ZUR GASPHASENABSCHEIDUNG EINER METALLBESCHICHTUNG AUF TEILEN AUS SUPERLEGIERUNGEN
METHOD AND TOOL FOR THE VAPOUR PHASE DEPOSITION OF A METAL COATING ONTO PARTS MADE OF SUPERALLOYS

(30) Priorité: 03.07.2012 FR 1256376
(43) Date de publication de la demande: 13.05.2015
(73) Titulaire: Safran Aircraft Engines, 75015 Paris (FR)
(72) Inventeur: RODRIGUEZ ELIZONDO, Gabriela, 77550 Moissy-Cramayel cedex (FR); VITRAC, Stephane, 77550 Moissy-Cramayel cedex (MX)
(74) Mandataire: Gevers & Orès
(86) Numéro de dépôt international: PCT/FR2013/051546
(87) Numéro de publication internationale: WO 2014/006317

(56) Documents cités:
- FR-A1- 2 900 416
- US-A- 4 965 095
- US-A1- 2002 102 357
- US-A1- 2004 112 287
- US-A1- 2004 151 834
- US-A1- 2006 147 625

## Description

### Domaine technique de l'invention

La présente invention concerne le dépôt d'un revêtement protecteur, notamment à base d'aluminium, sur une pièce métallique. Elle vise en particulier l'application d'un tel revêtement sur des pièces de turbomachines, aubes mobiles ou de stator de moteur à turbine à gaz.

### Etat de la technique

Un moteur à turbine à gaz, tel qu'utilisé pour la propulsion dans le domaine aéronautique fonctionne à une température des gaz moteurs entraînant les turbines que l'on souhaite aussi élevée que possible car le rendement énergétique lui est lié. Dans ce but les matériaux sont sélectionnés pour résister à ces conditions de fonctionnement et les parois des pièces balayées par les gaz chauds - distributeurs ou ailettes mobiles de turbine - sont pourvues le cas échéant de moyens internes de refroidissement. Par ailleurs, en raison de leur constitution métallique en superalliage à base de nickel ou de cobalt, il est nécessaire aussi de prémunir celles-ci de l'érosion et de la corrosion engendrées par les constituants des gaz moteurs à ces températures.

Un moyen connu pour assurer la protection de ces pièces est de déposer un revêtement métallique, de préférence à base d'aluminium, sur les surfaces susceptibles d'agression par les gaz. L'aluminium se fixe au substrat par interdiffusion métallique et forme une couche protectrice d'oxyde en surface. L'épaisseur du revêtement est de l'ordre de quelques dizaines de microns. Le document FR-A1-2900416 décrit un tel exemple de protection de pièce par un revêtement métallique.

La présente invention se rapporte à la technique, en soi connue, de dépôt de l'aluminium en phase vapeur ou encore désignée aluminisation par dépôt en phase vapeur. Selon le procédé, on dispose les pièces à traiter dans une enceinte semi étanche dans laquelle l'atmosphère est constituée d'un mélange d'un gaz inerte ou réducteur, par exemple argon ou hydrogène, et d'un gaz actif comprenant un halogénure d'aluminium. A la température de réaction, entre 900°C et 1150°C, l'halogénure se décompose à la surface de la pièce en halogène gazeux et en aluminium qui diffuse dans le métal.

On produit l'halogénure en disposant dans l'enceinte avec les pièces à traiter, un cément donneur d'aluminium métallique ou d'alliage métallique d'aluminium avec un ou plusieurs des constituants métalliques, notamment le chrome, du matériau formant les pièces à protéger, en présence de granules d'un composé d'halogène, chlore ou fluor, qui forment l'activateur. On fait circuler le gaz inerte sur l'activateur à une température permettant la sublimation de l'halogène qui est entraîné sur le donneur et avec lequel il réagit pour produire l'halogénure métallique qui, à cette température, est sous forme vapeur.

L'activateur devant être gazeux à la température du revêtement et ne pas produire de polluants, on choisit généralement des produits tels que le chlorure d'ammonium, le fluorure d'ammonium ou le bi-fluorure d'ammonium. En présence d'hydrogène ou sous gaz neutre et à température élevée, ces molécules se décomposent en ammoniac et en halogène. La température de vaporisation dépend de la nature du sel halogéné choisi. Par exemple, elle est de 340°C pour le chlorure d'ammonium. L'activateur n'est utilisé que pour transporter en toute sécurité un acide halogéné dans le réacteur où le dépôt doit être effectué, c'est à dire la boîte semi-étanche. Le cation lié à cet halogène (ici l'ammonium) est par voie de conséquence non utile à la réaction.

L'halogénure se décompose ensuite au contact du substrat métallique à revêtir permettant le dépôt de l'aluminium. Au cours de l'aluminisation il s'instaure un processus cyclique de dépôt d'aluminium se poursuivant continuellement jusqu'à ce que l'activité en aluminium de la surface du substrat devienne égale à celle imposée par le cément. L'halogène gazeux est reformé. Le revêtement obtenu sert éventuellement de couche intermédiaire entre le substrat métallique et une barrière de protection thermique de ce substrat sur lequel on vient l'appliquer. Le revêtement permet d'améliorer aussi bien la tenue de la barrière thermique sur le substrat que la capacité de ce dernier à conserver des caractéristiques d'usage en cas de dégradation de la barrière thermique.

La mise en oeuvre industrielle du procédé est cependant d'un cout élevé en raison notamment de la faible durée de vie des outillages et du temps de préparation.

L'équipement de l'art antérieur, comprend des boîtes de forme circulaire que l'on pose avec des entretoises en graphite en un ensemble cylindrique. Cet ensemble est placé dans un four de traitement sous atmosphère réductrice ou neutre. Il est convenu que pour obtenir une épaisseur suffisante de dépôt sur les pièces, le donneur d'aluminium doit être disposé verticalement dans des paniers entre les pièces en traitement.

Cette solution présente plusieurs inconvénients.

Les entretoises et les paniers occupent un espace important, réduisant le volume disponible pour les pièces, et rendant le système d'outillage complexe par les guides, les soudures, les fixations mécaniques et le poids qui leur sont associés.

Ils sont aussi, lorsqu'il y a par exemple contact et collage avec l'outillage, à l'origine de défauts sur les pièces les rendant non conformes.

Comme les outillages sont soumis au même traitement que les pièces, ils se déforment limitant leur durée de vie. Les déformations peuvent entraîner des fuites d'atmosphère aluminisante induisant l'obtention de pièces présentant des dépôts en dehors des tolérances prescrites.

La surface importante de l'outillage implique des dépôts parasites qui conduisent à des consommations élevées de donneur. Le rendement du procédé chute alors rapidement si on ne recharge pas le dispositif en donneur.

Le présent déposant a présenté une variante de ce type de procédé dans le brevet EP-B-068 950 selon lequel le donneur se présente sous la forme d'une tôle mince disposée, en cylindres concentriques par exemple, de manière à ce que chacune des surfaces à revêtir soit en face d'une tôle ou d'une portion de tôle dont la surface est du même ordre de grandeur.

Selon une autre variante décrite dans EP-B-349 420, au nom de la demanderesse également, le traitement est effectué dans une boîte avec un lit de donneur, le gaz étant introduit par le dessous du lit qui repose sur une grille.

### Objet de l'invention

Le déposant s'est fixé comme objectif d'améliorer le procédé en réduisant l'emprise de l'outillage sur celui-ci tout en augmentant le volume disponible pour disposer des pièces supplémentaires à l'intérieur des boites. En particulier le déposant a cherché à réduire la surface de l'outillage par rapport à celle des pièces, la quantité et le poids des équipements.

Le procédé conforme à l'invention est telle que définie dans la revendication 1.

En changeant la disposition du donneur, on supprime les contraintes liées aux supports des pièces. Les grains du donneur sont disposés en une couche sur le fond de la boîte, et les grains de l'activateur sont déposés sur les grains du donneur.

La solution est avantageuse car elle permet, en particulier :
- d'augmenter la densité des pièces dans le four pendant le traitement,
- de ne pas augmenter la consommation du donneur malgré le nombre de pièces plus élevé par opération,
- d'améliorer le rendement du procédé, en privilégiant les plans horizontaux pour maintenir les pièces et former des séparations étanches, les fuites sont réduites
- de réduire le coût des outillages et des équipements par pièce et, de manière générale de moins les solliciter,
- de concevoir des outillages plus simples et à plus grande durée de vie,
- de réduire le temps de cycle en réduisant les opérations de préparation des charges.

Par rapport à la solution de l'art antérieur avec emploi de paniers, on a constaté que, l'aluminisation en phase vapeur commençant avec un gaz qui se déplace dans l'enceinte, le gaz remplissait plus rapidement le volume complet de la boite. En outre, sans panier ni séparation verticale, le gaz peut aussi circuler beaucoup plus facilement. Par ailleurs l'aluminium se dépose plus facilement dans un volume juste occupé par les pièces. Enfin la surface, libre, de donneur au fond de la boite, sans barrière, est beaucoup plus importante ; Il n'y a aucune barrière ni élément perturbateur entre le donneur et les pièces.

Par rapport à la solution de EP-B-349 420, le fait, selon l'invention, d'alimenter en gaz à la fois par le coté, juste au-dessus du lit de donneur et par le couvercle, les boîtes sont purgées parfaitement jusqu'à 350 degrés et toute trace d'oxygène notamment est éliminée. Au contraire l'introduction d'argon par le dessous pose un problème de contamination des pièces par le soufflage de poussières. On a constaté par ailleurs que les canalisations sous le donneur avaient tendance à se boucher. Enfin la capacité d'aluminisation n'est pas optimale en raison de disposition de l'activateur par rapport à l'alimentation en gaz.

Avantageusement, on dispose les pièces dans au moins deux boîtes superposées, le fond de la boîte supérieure formant couvercle de la boîte inférieure qui comprend une colonne centrale de support de la boîte supérieure, un couvercle étant placé sur la boîte supérieure.

L'invention porte également sur un outillage tel que défini dans la revendication 5. Plus particulièrement, le bord supérieur des boîtes est agencé pour recevoir le fond de la boîte qui lui est placée dessus.

Avantageusement, la colonne centrale d'au moins une première boîte a une forme tubulaire dont le creux débouche en formant une ouverture centrale sous le fond de la boîte, et la colonne centrale d'au moins une deuxième boîte centrale présente une forme supérieure permettant le contact avec l'intérieur du bord de l'ouverture centrale du fond de la première boîte lorsque celle-ci est placée dessus

En s'emboîtant les unes dans les autres les colonnes centrales individuelles à chaque boîte reconstituent une colonne centrale globale qui reprend le poids du chargement pour chaque boîte au centre de son fond et qui, de plus, sert de structure centrale rigidifiant l'empilement des boîtes.

Les boîtes contiennent un support de pièces adapté. Selon une application, le support présente une plaque qui est parallèle au fond de la boîte et est pourvue d'ouvertures pour le logement des pièces. Avantageusement, le support comprend au plus une colonne de soutien de la plaque pour cinq ouvertures de logement des pièces. Le dispositif permet ainsi d'obtenir une densité élevée de pièces à traiter dans une boîte sans gêner la circulation du gaz pour le dépôt de la couche d'aluminium. L'application est par exemple le traitement d'aubes mobiles de turbine ou bien de chemises internes d'aubes creuses de turbomachine.

Selon une autre application, les boîtes comprennent des supports individuels pour distributeurs de turbine.

### Présentation des figures

D'autres caractéristiques et avantages ressortiront de la description qui suit d'un mode de réalisation de l'invention, non limitatif, en référence aux dessins annexés sur lesquels :
- La figure 1 montre, en coupe transversale, un outillage comprenant trois boîtes et un couvercle avant assemblage les unes sur les autres ;
- La figure 2 montre en perspective l'outillage de la figure 1 ;
- La figure 3 montre un secteur de support pour aubes mobiles de turbine ;
- La figure 4 montre un secteur de support pour chemises d'aubes de distributeur refroidie ;
- La figure 5 montre un support pour secteur de distributeur de turbine.

### Description détaillée d'un mode de réalisation

Le traitement thermochimique d'aluminisation consiste à enrichir superficiellement en aluminium la surface d'une pièce dans le but d'améliorer la tenue à l'oxydation à chaud, jusqu'à 1100°C, la tenue à la corrosion, notamment en présence simultanée d'oxygène, de soufre par le kérosène et/ou de chlorure de sodium par les embruns salins, et la zone dans laquelle on rencontre les phénomènes d'oxydation /corrosion dus à la température des gaz de combustion.

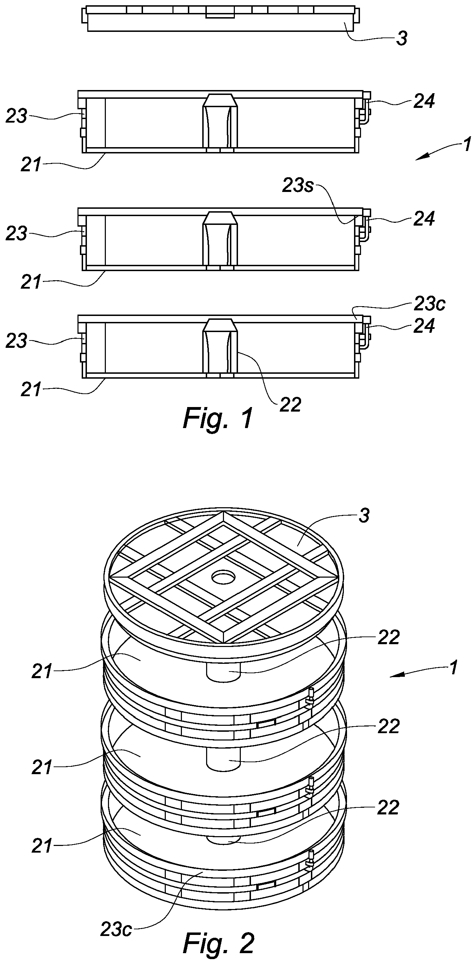

Les figures 1 et 2 montrent un exemple de réalisation d'un outillage conforme à l'invention. Il comprend un ensemble de trois boîtes 2, ici prêtes à être posées les unes sur les autres. Chaque boîte est de forme circulaire avec un plateau 21 formé d'une plaque renforcée de manière à pouvoir supporter un lit formé de grains de donneur et d'activateur ainsi que les pièces à traiter. La plaque 21 comprend, ici, une ouverture circulaire au centre avec une colonne 22 centrale creuse calée dans l'ouverture et formant support. La colonne a pour fonction de soutenir le fond et d'éviter qu'il ne se déforme. Suivant une caractéristique ne faisant pas partie de l'invention, la boîte comprend une paroi latérale 23 de même hauteur que la colonne 22. Cette paroi est renforcée par des nervures périphériques. Un tube 24 est disposé sur la paroi 23 et débouche dans la boîte. Il sert à alimenter la boîte en gaz neutre, tel que l'argon, ou réducteur. Le bord supérieur 23s de la paroi 23 est pourvu d'une tôle périphérique de centrage 23c. Un couvercle 3 vient fermer la boîte supérieure.

Pour assembler l'outillage, on place la boîte du milieu sur la boîte inférieure, le fond venant en appui sur le bord de la boîte inférieure à l'intérieur de la tôle périphérique 23c de centrage et sur la colonne 22 au centre dont la forme tronconique supérieure permet un contact avec le bord de l'ouverture centrale de la boîte qui repose dessus. On place la boîte supérieure sur la boîte du milieu de la même façon. Les efforts verticaux sont transmis le long des parois latérales par les bords des boîtes et les colonnes centrales.

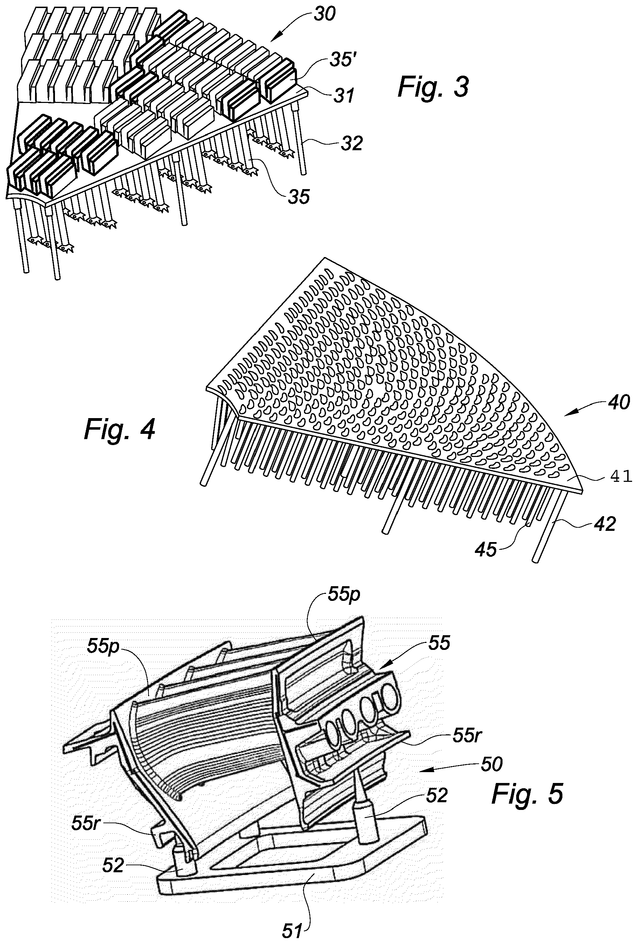

Pour charger les boîtes, on dispose de supports adaptés aux pièces à traiter. Sur la figure 3 on a représenté un secteur de support 30 pour des aubes mobiles 35. Les pieds des aubes sont enfermés dans des masques 35' qui ont pour fonction précisément d'empêcher l'aluminisation de cette partie des pièces. Il est souhaité en effet que cette partie ne soit pas traitée. Les aubes sont ainsi suspendues tête en bas dans la plaque 31 du support dont le nombre et la disposition des logements sont déterminés de manière à avoir un chargement maximum compte tenu de l'encombrement des pièces et de la nécessité de ne pas avoir de contact. Contrairement aux outillages de l'art antérieur, on n'a pas de contraintes concernant la position des pièces à traiter par rapport au donneur puisque celui-ci est placé sous les pièces et non entre celles-ci. Suivant une caractéristique ne faisant pas partie de l'invention, la hauteur des colonnes 32 du support correspond à la hauteur des parois latérales 23 des boîtes et à la nécessité de maintenir un espace suffisant avec le fond pour qu'il n'y ait pas de contact entre le donneur et les pièces. Par exemple, la plaque 31 du support 30 couvre un secteur de 60 degrés dans le volume annulaire intérieur de la boîte 2, la plaque peut recevoir cinquante sept aubes 35, et seulement neuf colonnes 32 réparties sur sa superficie suffisent à lui assurer une assise stable. Pour le chargement d'une boîte 2, on commence par disposer une couche de grains de donneur sur le fond de la boîte 2, puis une couche de grains d'activateur. Les aubes sont placées dans les secteurs de support 30. Puis les supports chargés sont mis en place dans la boîte 2. En effet, le lit de grain de donneur est utilisé comme un ballast toujours plan sur lequel les supports sont posés de manière très stable sans risque de déséquilibres entraînant des contacts entre les pièces. On procède de la même façon avec les autres boîtes puis on place le couvercle sur l'ensemble des trois boîtes chargées et on enfourne l'outillage chargé pour le traitement. Pour le traitement, on purge les enceintes fermées individuelles que constituent les boîtes et la plaque de fermeture ; puis on procède au chauffage progressif des enceintes balayées par le gaz argon par exemple, introduit par les tubes 24, jusqu'à 350 degrés. A cette température la purge est stoppée.

Sur la figure 4, on a représenté un secteur de support 40 pour des chemises 45 intérieures de distributeurs, telles que décrites par exemple dans la demande de brevet FR 2.921.937 au nom de la demanderesse. Contrairement aux aubes mobiles, la pièce peut être traitée sur toute sa surface et ne nécessite pas de masquage. Comme on le voit sur la figure, il est possible, de ce fait, de disposer un plus grand nombre de pièces sur le support 40. Le support comprend une plaque 41 percée de logements individuels pour les chemises 45 qui sont ainsi suspendues et retenues par leur collerette à une extrémité. La hauteur des colonnes 42 est déterminée comme précédemment en fonction de la couche formée des grains de donneur et d'activateur déposés sur le fond de la boîte. Dans cet exemple, la plaque 41 du support 40 peut recevoir trois cent trente trois chemises 45 de distributeur avec seulement sept colonnes 42 pour son soutien.

Sur la figure 5, on a représenté un support 50 pour secteur 55 de distributeur de turbine. La forme de ce dernier ne permet pas sa suspension au travers d'une plaque. Les distributeurs sont supportés individuellement sur un support 50 qui comprend un pied 51 et trois colonnes d'appui 52. Le secteur de distributeur comprend deux plateformes 55p reliant les pales du secteur entre elles et des brides radiales 55b extérieures aux pales par rapport aux plateformes 55p. Le secteur repose sur les colonnes d'appui 52 par les brides radiales 55r. Dans la boîte de l'outillage le support repose par le pied 51 sur la couche de grains de donneur et d'activateur. La hauteur des colonnes est suffisante pour éviter tout contact entre le donneur et le secteur de distributeur.

La solution de l'invention permet un gain significatif par rapport au procédé de l'art antérieur avec paniers contenant les grains de donneur et une amélioration de la qualité de la couche d'aluminium. Le gain se traduit par une plus grande densité de pièces traitées par fournée. La densité est multipliée par au moins 2,5 pour les aubes mobiles, jusqu'à 10 pour les chemises.

Simultanément, le coût des outillages et des consommables a été divisé par trois : la durée de vie des boîtes est trois fois plus longue ; la durée de vie du donneur a été multipliée par quatre, les paniers du donneur ont été éliminés ainsi que les artifices de fixation. La simplification a en outre permis de diviser par deux la durée d'un cycle d'opération.

## Revendications

1. Procédé de dépôt d'un revêtement métallique en phase vapeur sur des pièces (35, 45) en alliage résistant à chaud, comprenant :
- la disposition d'au moins une boîte formant une enceinte, la boîte comprenant un fond (21),
- la disposition dans l'enceinte de grains d'un donneur dudit métal de revêtement et d'un activateur susceptibles de former ensemble un halogénure du métal de revêtement,
- la disposition de pièces dans l'enceinte, et
- le chauffage de l'enceinte sous atmosphère d'un gaz neutre ou réducteur, jusqu'à une température de réaction de l'halogénure du métal de revêtement avec l'alliage des pièces, et le gaz étant introduit dans la boîte, lorsque ladite boîte est fermée, par le côté au-dessus du lit de grains,
**caractérisé par le fait que** le procédé comprend la disposition sur le fond (21) de l'enceinte d'un lit de grains du donneur dudit métal de revêtement et de l'activateur susceptibles de former ensemble l'halogénure du métal de revêtement et la pose d'un support des pièces (35, 45) sur le lit de grains, ce support comportant une plaque (31, 41) à laquelle les pièces (35, 45) sont suspendues et des colonnes de soutien (32, 42) de ladite plaque, les pièces étant maintenues à distance et libres de tout contact du lit de grains.

2. Procédé selon la revendication précédente, selon lequel on enferme une partie de chaque pièce (35) ne devant pas être recouverte dans un masque (35').

3. Procédé selon la revendication précédente, selon lequel ladite pièce (35) est suspendue dans la plaque (31) du support, de manière à retenir une partie de la pièce (35) non recouverte par ledit masque (35') sous la plaque (31).

4. Procédé selon l'une des revendications 1 à 3, selon lequel on dispose les pièces dans au moins deux boîtes superposées, le fond (21) de la boîte supérieure formant couvercle de la boîte inférieure qui comprend une colonne centrale de support de la boîte supérieure, un couvercle (3) étant placé sur la boîte supérieure.

5. Outillage pour la mise en œuvre du procédé selon l'une des revendications précédentes comprenant au moins une première boîte (2) et une deuxième boîte superposées, et un support (30, 40) de pièces adaptés aux pièces à traiter et à être mise en place chargé dans chaque première et deuxième boîte, chaque première et deuxième boîte comprenant un fond (21) et au moins une paroi latérale (23), le support (30, 40) de pièces étant posé sur le lit de grains destiné à être disposé sur le fond (21) de chaque première et deuxième boîte, ledit support de pièces présentant une plaque (31, 41) maintenue parallèle au fond (21) et, percée de logements permettant la suspension des pièces, ledit support étant supporté par des colonnes de soutien (32, 42) configurées de manière à maintenir les pièces à distance et libres de tout contact du lit de grains.

6. Outillage selon la revendication précédente, dont le support (30, 40) est agencé pour recevoir des aubes mobiles de turbine et comporte au plus une colonne de soutien (32) de la plaque (31) pour quatre logements de suspension des pièces.

7. Outillage selon la revendication 5, dont le support (40) est agencé pour recevoir des chemises internes d'aubes creuses de turbomachine et comporte au plus une colonne de soutien (42) de la plaque (41) pour vingt logements de suspension des pièces.

8. Outillage selon l'une des revendications 5 à 7, comprenant la première et la deuxième boîtes (2) sont en métal à fond (21) plat, chaque boîte ayant une forme circulaire et comportant une colonne centrale (22) formant support, un couvercle (3) recouvrant la boîte supérieure, ainsi qu'un tube (24) débouchant à l'intérieur de sa paroi latérale et au moins un support (30, 40, 50) de pièces comportant des colonnes de soutien (32, 42, 52).

9. Outillage selon la revendication précédente dont le bord supérieur (23s) des boîtes est agencé pour recevoir le fond (21) de la boîte qui lui est placée dessus.

10. Outillage selon la revendication précédente comprenant au moins première
une boîte dont la colonne centrale (22) a une forme tubulaire dont le creux débouche en formant une ouverture centrale sous le fond (21) de la boîte, et au moins une deuxième boîte dont la colonne centrale (22) présente une forme supérieure permettant le contact avec l'intérieur du bord de l'ouverture centrale du fond (21) de la première boîte lorsque celle-ci est placée dessus.

## Patentansprüche

1. Verfahren zum Aufbringen einer Metallschicht aus der Dampfphase auf wärmebeständige Legierungsteile (35, 45), das Folgendes umfasst:
- die Anordnung von zumindest einem Kasten, der eine Umgrenzung bildet, wobei der Kasten einen Boden (21) umfasst,
- die Anordnung in der Umgrenzung von Körnern eines Donators des Beschichtungsmetalls und eines Aktivators, die sich dazu eignen, zusammen ein Halogenid des Beschichtungsmetalls zu bilden,
- die Anordnung von Teilen in der Umgrenzung, und
- das Erwärmen der Umgrenzung unter Atmosphäre eines neutralen oder reduzierenden Gases bis zu einer Reaktionstemperatur des Halogenids des Beschichtungsmetalls mit der Legierung der Teile, und wobei das Gas von der Seite über dem Kornbett in den Kasten eingeleitet wird, wenn der Kasten geschlossen ist,
**dadurch gekennzeichnet, dass** das Verfahren die Anordnung eines Kornbettes des Donators des Beschichtungsmetalls und des Aktivators, die dazu geeignet sind, zusammen das Halogenid des Beschichtungsmetalls zu bilden, auf dem Boden (21) der Umgrenzung und das Anbringen eines Trägers für die Teile (35, 45) auf dem Kornbett umfasst, wobei dieser Träger eine Platte (31, 41), an der die Teile (35, 45) aufgehängt sind, und Tragsäulen (32, 42) der Platte umfasst, wobei die Teile in einem Abstand und frei von jeglichem Kontakt von dem Kornbett gehalten werden.

2. Verfahren nach dem vorstehenden Anspruch, wobei ein Abschnitt jedes Teiles (35), der nicht bedeckt werden soll, in einer Maske (35') eingeschlossen wird.

3. Verfahren nach dem vorstehenden Anspruch, wobei das Teil (35) in der Platte (31) des Trägers aufgehängt wird, um einen Abschnitt des Teils (35), der nicht von der Maske (35') bedeckt ist, unter der Platte (31) zu halten.

4. Verfahren nach einem der Ansprüche 1 bis 3, wobei die Teile in zumindest zwei übereinandergesetzte Kästen angeordnet werden, wobei der Boden (21) des oberen Kastens die Abdeckung des unteren Kastens bildet, der eine zentrale Säule zum Tragen des oberen Kastens umfasst, wobei eine Abdeckung (3) auf den oberen Kasten aufgesetzt wird.

5. Werkzeugausrüstung zur Durchführung des Verfahrens nach einem der vorstehenden Ansprüche, das zumindest einen ersten Kasten (2) und einen zweiten Kasten, die übereinandergesetzt sind, und einen Träger (30, 40) für Teile, der für die zu bearbeitenden Teile und für die beladene Anordnung in jeden ersten und zweiten Kasten geeignet ist, umfasst, wobei jeder erste und zweite Kasten einen Boden (21) und zumindest eine Seitenwand (23) umfasst, wobei der Träger (30, 40) für Teile auf dem Kornbett angeordnet ist, das dazu bestimmt ist, auf dem Boden (21) jedes ersten und zweiten Kastens angeordnet zu werden, wobei der Träger für Teile eine Platte (31, 41) aufweist, die parallel zum Boden (21) gehalten wird und die mit Aufnahmen durchsetzt ist, die das Aufhängen der Teile ermöglichen, wobei der Träger von Tragsäulen (32, 42) getragen wird, die so ausgestaltet sind, dass die Teile in einem Abstand und frei von jeglichem Kontakt mit dem Kornbett gehalten werden.

6. Werkzeugausrüstung nach dem vorstehenden Anspruch, wobei der Träger (30, 40) angeordnet ist, bewegliche Turbinenschaufeln aufzunehmen, und höchstens eine Tragsäule (32) der Platte (31) für vier Aufnahmen für die Aufhängung der Teile umfasst.

7. Werkzeugausrüstung nach Anspruch 5, wobei der Träger (40) angeordnet ist, um Innenauskleidungen von hohlen Turbinenmotorschaufeln aufzunehmen, und höchstens eine Tragsäule (42) der Platte (41) für zwanzig Aufnahmen für die Aufhängung der Teile umfasst.

8. Werkzeugausrüstung nach einem der Ansprüche 5 bis 7, die den ersten und zweiten Kasten (2) aus Metall mit flachem Boden (21) umfasst, wobei jeder Kasten eine kreisförmige Form aufweist und eine zentrale Säule (22), die einen Träger bildet, eine Abdeckung (3), die den oberen Kasten abdeckt, sowie ein Rohr (24), das in das Innere seiner Seitenwand mündet, und zumindest einen Träger (30, 40, 50) für Teile, die Tragsäulen (32, 42, 52) umfassen, umfasst.

9. Werkzeugausrüstung nach dem vorstehenden Anspruch, wobei der obere Rand (23s) der Kästen so angeordnet ist, dass er den Boden (21) des aufgesetzten Kastens aufnimmt.

10. Werkzeugausrüstung nach dem vorstehenden Anspruch, die zumindest einen ersten Kasten, dessen zentrale Säule (22) eine röhrenförmige Form aufweist, deren Hohlraum unter Bildung einer zentralen Öffnung unter dem Boden (21) des Kastens mündet, und zumindest einen zweiten Kasten, dessen zentrale Säule (22) eine obere Form aufweist, die den Kontakt mit dem Inneren des Randes der zentralen Öffnung des Bodens (21) des ersten Kastens ermöglicht, wenn dieser aufgesetzt ist, umfasst.

## Claims

1. A method for depositing a metal coating in vapour phase onto parts (35, 45) made of heat resistant alloy, comprising:
- arranging at least one box forming an enclosure, the box comprising a bottom (21),
- arranging in the enclosure of grains of a donor of said coating metal and an activator capable of together forming a halide of the coating metal,
- arranging parts in the enclosure, and
- heating the enclosure under an inert gas or reducing gas atmosphere to a temperature at which the halide of the coating metal reacts with the alloy of the parts, and the gas being injected into the box, when the box is closed, via the side above the bed of grains,
**characterised in that** the method comprises arranging on the bottom (21) of the enclosure a bed of grains of the donor of said coating metal and the activator capable of together forming the halide of the coating metal and placing a support for supporting the parts (35, 45) on the bed of grains, this support comprising a plate (31, 41) from which the parts (35, 45) are suspended and columns (32, 42) for supporting said plate, the parts being kept separate from and free of any contact with the bed of grains.

2. The method according to the preceding claim, wherein a portion of each part (35) not to be covered is enclosed in a mask (35').

3. The method according to the preceding claim, according to which said part (35) is suspended in the plate (31) of the support, so as to retain a portion of the part (35) not covered by said mask (35') under the plate (31).

4. The method according to one of claims 1 to 3, according to which the parts are arranged in at least two superimposed boxes, the bottom (21) of the upper box forming a cover for the lower box which comprises a central column for supporting the upper box, a cover (3) being placed on the upper box.

5. A tool for implementing the method according to one of the preceding claims comprising at least a first box (2) and a second box superimposed on each other, and a part support (30, 40) adapted to the parts to be treated and to be placed loaded in each first and second box, each first and second box comprising a bottom (21) and at least one lateral wall (23), the part support (30, 40) being placed on the bed of grains intended to be arranged on the bottom (21) of each first and second box, said part support having a plate (31, 41) kept parallel to the bottom (21) and pierced with recesses allowing the suspension of the parts, said support being supported by support columns (32, 42) configured in such a way as to keep the parts at a distance from and free of any contact with the bed of grains.

6. The tool according to the preceding claim, the support (30, 40) of which is disposed to receive movable turbine blades and comprises at most one column (32) for supporting the plate (31) for four recesses for suspension of the parts.

7. The tool according to claim 5, the support (40) of which is arranged to receive inner liners of hollow turbine engine blades and comprises at most one column (42) for supporting the plate (41) for twenty suspension recesses of the parts.

8. The tool according to one of claims 5 to 7, comprising the first and second boxes (2) are made of metal with a flat bottom (21), each box having a circular shape and comprising a central column (22) forming a support, a cover (3) covering the upper box, as well as a tube (24) opening out inside its lateral wall and at least one support (30, 40, 50) for supporting parts comprising support columns (32, 42, 52).

9. The tool according to the preceding claim, whose upper edge (23s) of the boxes is arranged to receive the bottom (21) of the box placed thereon.

10. The tool according to the preceding claim comprising at least a first box, the central column (22) of which has a tubular shape, the hollow of which opens out to form a central opening under the bottom (21) of the box, and at least a second box, the central column (22) of which has an upper shape allowing contact with the inside of the edge of the central opening of the bottom (21) of the first box when the latter is placed on top.
